# FASCICULE DE BREVET EUROPEEN

(11) **EP 2 845 227 B1**
(45) Date de publication et mention de la délivrance du brevet: **14.09.2016**
(21) Numéro de dépôt: 13706581.9
(22) Date de dépôt: 28.01.2013
(51) Int. Cl.: H01L 31/0463, H01L 31/18

(54) **GRAVURE PAR LASER D'UN EMPILEMENT DE COUCHES MINCES POUR UNE CONNEXION DE CELLULE PHOTOVOLTAÏQUE**
LASERÄTZUNG EINES DÜNNSCHICHTSTAPELS FÜR EINEN ANSCHLUSS EINER PHOTOVOLTAIKZELLE
LASER ETCHING OF A THIN LAYERS STACK FOR A CONNECTION OF A PHOTOVOLTAIC CELL

(30) Priorité: 03.05.2012 FR 1254088
(43) Date de publication de la demande: 11.03.2015
(73) Titulaire: Nexcis, 13106 Rousset (FR)
(72) Inventeur: Dunne, Brendan, F-13106 Rousset (FR)
(74) Mandataire: Cabinet Camus Lebkiri
(86) Numéro de dépôt international: PCT/FR2013/050174
(87) Numéro de publication internationale: WO 2013/164523

(56) Documents cités:
- DE-A1-102009 026 411
- JP-A- 2011 077 112
- US-A1- 2010 170 558
- US-A1- 2011 030 758
- US-B2- 7 718 347

## Description

La présente invention concerne la conception de cellules photovoltaïque, notamment pour des panneaux solaires, en particulier à base d'une couche active comportant une stoechiométrie de type I-III-VI₂.

De telle couches actives à propriétés photovoltaïques comportent en général les espèces cuivre - indium, aluminium et/ou gallium - sélénium et/ou soufre. Le matériau qui en résulte est appelé ci-après « CIGS ». Dans la cellule à connecter, une couche mince de ce matériau est généralement recouverte par une couche transparente conductrice formant une électrode avant de la cellule (souvent en oxyde de zinc, ZnO) et une couche transparente (souvent en sulfure de cadmium, CdS), formant tampon entre la couche photovoltaïque et la couche d'électrode.

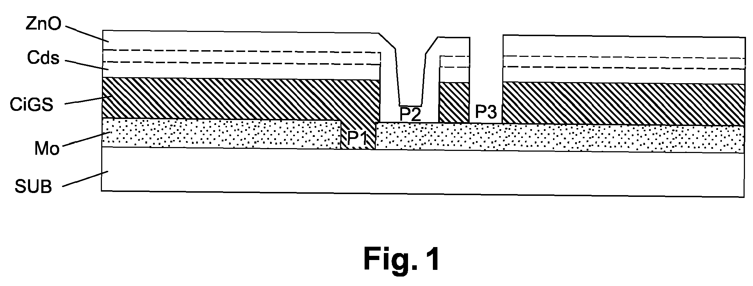

Il est décrit notamment dans le document :
« Picosecond Laser Structuring for the Monolithic Serial Interconnection of CIS Solar Cells » (P.Huber et al), 24th European Photovoltaic Solar Energy Conference, 21-25 September 2009, Hambourg, Allemagne,
une structure de cellules solaires comportant (comme illustré sur la figure 1 ci-annexée) :
   - un substrat SUB, en particulier en verre ;
   - sur lequel est déposé une couche de contact, souvent de molybdène Mo (représentée sur les dessins par des points lorsqu'elle est montrée en coupe) ;
   - sur laquelle est déposé une couche de CIGS à propriété photovoltaïque (représentée sur les dessins par des hachures obliques lorsqu'elle est montrée en coupe) ;
   - sur laquelle d'autres couches sont déposées pour la conception complète de la cellule, notamment du sulfure de cadmium CdS et de l'oxyde de zinc ZnO.

En particulier, pour créer les connexions d'une cellule résultant d'un tel empilement, des motifs de gravure P1, P2, P3, sont effectués.

Plus particulièrement, concernant le motif P1 représenté sur la figure 1 :
- la couche de molybdène Mo est gravée localement ; et
- la couche de CIGS est déposée ensuite sur le substrat laissé à nu suite à la gravure locale du molybdène.

On relèvera plus particulièrement que la couche de CIGS doit être déposée directement sur le substrat en verre SUB.

Or, une technique de dépôt de la couche de CIGS, qui se révèle particulièrement avantageuse industriellement et économiquement, consiste en l'électrolyse d'au moins des précurseurs de la couche de CIGS (souvent les espèces I et III, l'espèce VI pouvant être apportée ultérieurement pendant un traitement thermique).

Néanmoins, ce dépôt par électrolyse doit s'effectuer sur un support conducteur, habituellement le molybdène Mo.

On comprendra donc que cette technique classique de gravure selon le motif P1 au sens de l'art antérieur présenté ci-avant est incompatible avec un dépôt par électrolyse. En effet, une électrolyse directement sur le substrat SUB (en verre isolant), mis à nu suite à la gravure du molybdène, est ici impossible.

Le document US 7 718 347 B2 décrit également un procédé de traitement de couches minces en vue d'une formation de connexion de cellule photovoltaïque.

La présente invention vient améliorer la situation.

Elle propose à cet effet un procédé de traitement de couches minces, en vue d'une formation de connexion de cellule photovoltaïque comportant lesdites couches minces, lesdites couches minces comportant au moins:
- une première couche, à propriétés photovoltaïques, déposée sur une deuxième couche, et
- ladite deuxième couche, de contact métallique, déposée sur un substrat.

Le procédé comporte en particulier les étapes :
- graver, dans ladite première couche, au moins une première tranchée de première largeur pour une mise à nu de la deuxième couche ; et
- graver, dans ladite première tranchée, une deuxième tranchée pour une mise à nu du substrat, la deuxième tranchée étant d'une deuxième largeur inférieure à la première largeur.

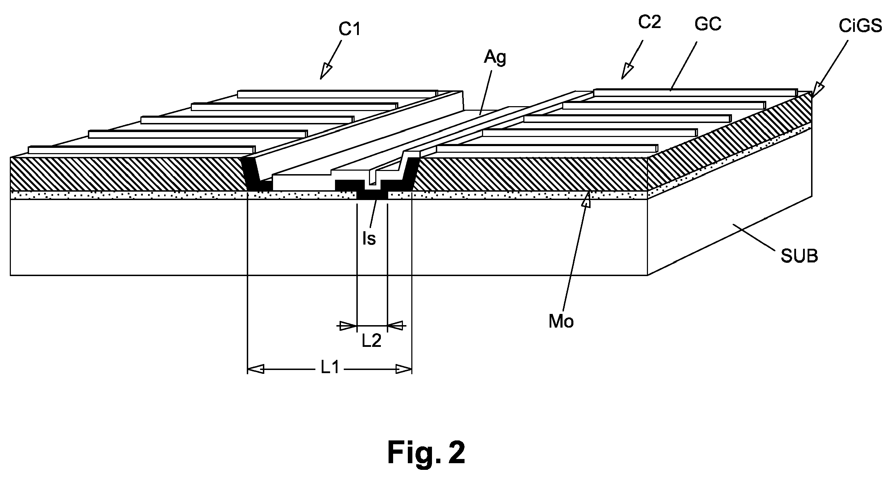

Ainsi, le procédé au sens de l'invention permet de déposer la première couche par électrolyse, sur la couche de contact et de graver ensuite la première tranchée, et la deuxième tranchée dans la première tranchée (références respectives L1 et L2 de la figure 2 décrite en détails ci-après).

En termes plus génériques, dans un exemple de réalisation, le dépôt de la première couche précitée peut alors comporter au moins une étape de dépôt par électrolyse (par exemple de précurseurs de la première couche), et ce possiblement avec un substrat en verre.

Dans le procédé au sens de l'invention, la gravure de la deuxième tranchée est réalisée par tirs lasers. Une telle technique de gravure est avantageuse pour réaliser des gravures fines (par exemple de largeur comprise entre 30 et 50 µm) pour la deuxième tranchée.

Il convient d'indiquer qu'en revanche, la première tranchée (formée dans la couche photovoltaïque) est plus large, par exemple de l'ordre de 300 µm de large, et peut être réalisée par tirs lasers ou simplement par rayure mécanique. Une telle tranchée, de 300 µm de large, permet avantageusement de disposer d'un espace suffisant pour placer des motifs d'isolation, d'interconnexion, ou autres.

Il est avantageux, dans le procédé au sens de l'invention, d'effectuer les deux gravures (première et deuxième tranchées) au cours d'une même étape globale de gravure, et par tirs lasers toutes les deux.

Ainsi, dans le procédé au sens de l'invention, les gravures des première et deuxième tranchées sont réalisées par tirs lasers, pendant une même étape globale de gravure.

La gravure laser apporte de nombreux avantages, notamment en termes de précision, de vitesse de traitement, avec moins d'écailles que peut générer habituellement un traitement mécanique (ce qui procure aussi un gain en place).

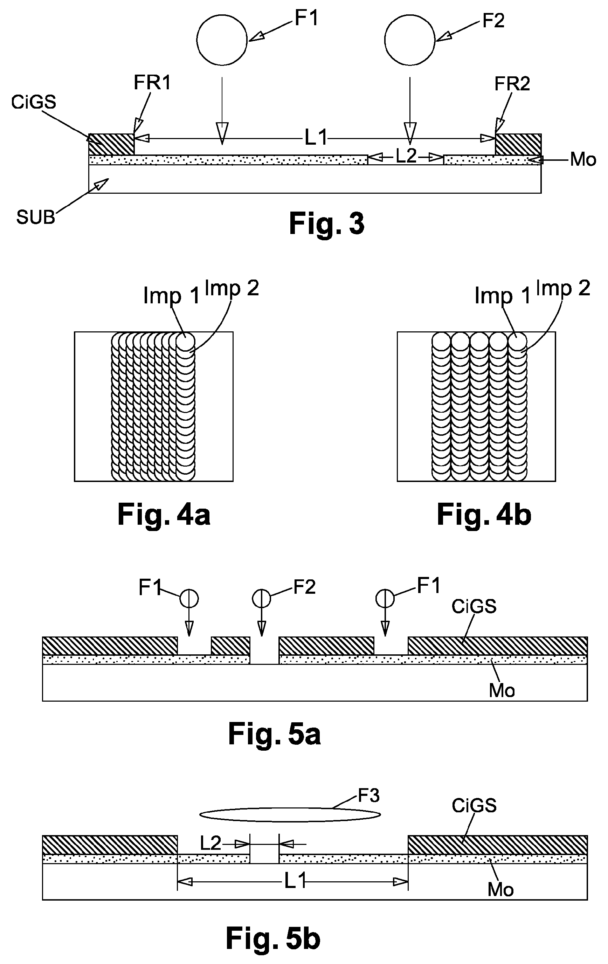

Comme on le verra en détails dans la description ci-après en référence aux dessins, l'étape globale de gravure peut comporter :
- une opération de gravure fine à proximité de bords latéraux de la première tranchée, avec des tirs lasers formant des impacts se recouvrant partiellement selon deux dimensions de surface de la première couche et/ou de la deuxième couche (comme illustré sur la figure 4a), et
- une opération de gravure grossière au milieu de la première tranchée, avec des tirs lasers formant des impacts se recouvrant partiellement selon une seule dimension de surface de la première couche et/ou de la deuxième couche (figure 4b), l'opération de gravure fine s'étendant sur une largeur globale comprise entre 20 et 40% de la largeur de la première tranchée, par exemple de 10 à 20% à gauche et de 10 à 20% à droite dans la première tranchée.

Ainsi, si par exemple la largeur L1 de la première tranchée est de 300 µm, l'opération de gravure fine peut être appliquée :
- sur une largeur de la première tranchée de 30 à 50 µm par exemple, comptés en partant de son bord latéral gauche vers son milieu, et
- sur une largeur de la première tranchée de 30 à 50 µm par exemple, comptés en partant de son bord latéral droit vers son milieu.

L'opération de gravure fine au moins est avantageusement réalisée à l'aide d'un laser à faisceau gaussien par exemple de diamètre compris entre 30 et 50 µm.

Selon des essais ayant donné des résultats satisfaisants, l'opération de gravure fine au moins est réalisée à l'aide d'un laser femtoseconde de longueur d'onde comprise entre 400 et 600 nm.

L'opération de gravure grossière peut être réalisée à l'aide d'un laser à faisceau plus large, par exemple elliptique et de largeur correspondant à la largeur de la première tranchée.

Par ailleurs, la deuxième tranchée au moins est préférentiellement réalisée à l'aide d'un laser à faisceau gaussien par exemple de diamètre compris entre 30 et 50 µm si la deuxième tranchée est de largeur comprise typiquement entre 30 et 100 µm.

La deuxième tranchée au moins peut être réalisée à l'aide d'un laser femtoseconde de longueur d'onde comprise entre 1000 et 1200 nm.

Comme on le verra dans les exemples de réalisation présentés ci-après, les tirs lasers peuvent être de fluence comprise entre de 0,2 et 0,5 J/cm², et peuvent déposer une quantité d'énergie par tir comprise entre 0,15 J/mm² et 0,3 J/mm².

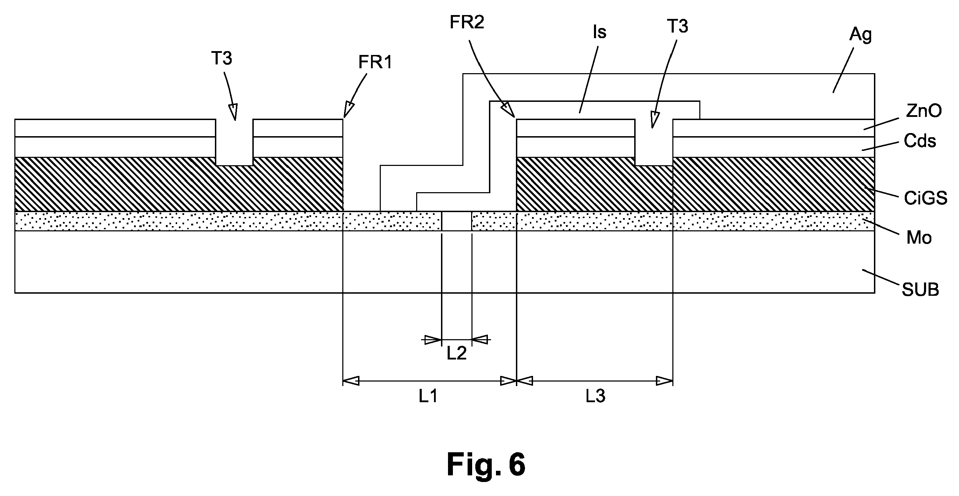

On peut utiliser un laser femtoseconde pour graver les première et deuxième tranchées précitées, comme décrit ci-dessus, en particulier pour soigner l'état des fronts délimitant la première tranchée. Toutefois, une variante de réalisation représentée sur la figure 6 décrite en détails plus loin permet d'utiliser un laser nanoseconde pour graver les première et deuxième tranchées (de largeurs L1 et L2 sur la figure 6). En revanche, cette réalisation prévoit de graver une troisième tranchée (référence T3 de la figure 6) pour mettre à nu la première couche (photovoltaïque) et il est préférable que cette troisième gravure s'effectue avec un laser femtoseconde. Ainsi, dans une telle réalisation, la première couche (photovoltaïque) étant revêtue d'au moins une troisième couche, généralement transparente, le procédé comporte en outre une gravure de la troisième tranchée précitée dans la troisième couche pour une mise à nu de la première couche, et en préférentiellement :
- la gravure de la troisième tranchée est réalisée à l'aide d'un laser femtoseconde,
- tandis que la gravure des première et deuxième tranchées est réalisée à l'aide d'un laser nanoseconde.

De façon générale, la première couche précitée, à propriétés photovoltaïques, est, dans un mode de réalisation, à base d'un matériau de stoechiométrie I-III-VI₂, par exemple à base d'un alliage de cuivre - indium, gallium et/ou aluminium - sélénium et/ou soufre.

Il a été observé alors qu'un laser femtoseconde se prêtait avantageusement à la gravure sèche (par ablation) d'un tel matériau, en présentant notamment des fronts de gravure nets et bien délimités.

En outre, la première couche peut être revêtue d'au moins une troisième couche transparente (par exemple une couche d'électrode avant ZnO et/ou au moins une couche tampon transparente CdS). L'étape de gravure est avantageuse en ce que la première tranchée précitée, au moins, est formée à la fois dans la première et la troisième couche. A cet effet, un laser femtoseconde peut être encore prévu.

A ce titre, on comprendra que l'utilisation d'un laser femtoseconde pour graver une couche de stoechiométrie I-III-VI₂, revêtue éventuellement d'une ou plusieurs couches transparentes, est avantageuse en soi et pourrait faire l'objet d'une protection séparée.

Par ailleurs, dès lors que le motif de gravure, pour une connexion entre cellules photovoltaïques, correspondant à une « fine » tranchée L2 dans une « large » tranchée L1, est avantageux par rapport au motif « P1 » de l'état de l'art présenté ci-avant en référence à la figure 1, le procédé, au sens de la présente invention, permet d'obtenir une cellule photovoltaïque comportant un tel motif de connexion, et plus particulièrement :
- au moins une première couche, à propriétés photovoltaïques, déposée sur une deuxième couche, et
- la deuxième couche, de contact métallique, déposée sur un substrat.

La cellule comporte un motif de connexion comprenant en particulier :
- une première tranchée de première largeur gravée dans la première couche avec une mise à nu de la deuxième couche ; et
- une deuxième tranchée gravée dans la première tranchée, avec une mise à nu du substrat, la deuxième tranchée étant d'une deuxième largeur inférieure à la première largeur.

Par exemple, la première tranchée peut être de largeur comprise entre 200 et 500 µm et la deuxième tranchée peut être de largeur comprise entre 30 et 100 µm.

D'autres avantages et caractéristiques de l'invention apparaîtront à la lecture de la description détaillée ci-après d'exemples de réalisation et à l'examen des dessins annexés sur lesquels :
- la figure 1 illustre un motif de gravure (P1) au sens de l'art antérieur,
- la figure 2 illustre un motif de gravure pour une connexion inter-cellules au sens de l'invention à deux tranchées de largeurs respectives L1 et L2,
- la figure 3 illustre un exemple de forme de faisceaux lasers possibles pour la mise en oeuvre de la gravure au sens de l'invention,
- la figure 4a illustre les impacts de tirs lasers à proximité des fronts de tranchée FR1 et FR2 de la première tranchée, et la figure 4b illustre les impacts de tirs lasers plutôt au milieu de la première tranchée (à distance des fronts FR1 et FR2) selon un premier mode de réalisation de l'invention,
- les figures 5a et 5b illustrent deux opérations successives d'une étape globale de gravure, dans une réalisation possible de l'invention,
- la figure 6 illustre les opérations successives de gravure, puis de connexion, dans une variante de réalisation ;
- la figure 7 illustre les impacts de tirs lasers selon un second mode de réalisation de l'invention ;
- la figure 8 illustre les impacts de tirs lasers selon un troisième mode de réalisation de l'invention ;
- la figure 9 illustre les impacts de tirs lasers selon un quatrième mode de réalisation de l'invention.

L'invention propose, en vue de la préparation d'une connexion entre deux cellules photovoltaïques, un autre type de motif de gravure que le motif P1 présenté ci-avant en référence à la figure 1 de l'art antérieur.

A titre d'exemple, un motif différent est présenté sur la figure 2 et comporte ;
- une gravure de la couche de CIGS sur toute une largeur L1,
- ainsi qu'une gravure de la couche de métal sous-jacente (par exemple de molybdène) Mo, d'une largeur inférieure L2, et formée dans la tranchée (ou la « gorge » selon les termes utilisés ci-après) résultant de la gravure de la couche de CIGS.

La gravure de largeur L2 dans la couche de contact Mo permet de séparer électriquement les cellules photovoltaïques les unes des autres (C1 et C2 comme représenté sur la figure 2). Un film conducteur Ag (réalisé souvent en argent) est appliqué ensuite pour relier électriquement une grille de collecte GC disposée sur la couche de CIGS de la cellule C2 à la couche de contact Mo sous-jacente de la couche de CIGS de la cellule adjacente C1. La référence Is de la figure 2 désigne un film isolant (en noir dans sa représentation en coupe sur la figure 2), pour assurer une séparation électrique de la couche de CIGS de la cellule C2 avec la couche de contact Mo de la cellule C1.

Les tranchées de largeurs respectives L1 et L2 sont réalisées par gravure laser. Cette réalisation permet, comme on le verra ci-après, de former les deux tranchées simultanément ou tout au moins immédiatement l'une à la suite l'une de l'autre.
En se référant maintenant à la figure 3, un premier faisceau F1 pratique la gravure laser pour former la tranchée de largeur L1 (dans la couche de CIGS), tandis qu'un deuxième faisceau laser F2 pratique la gravure laser pour former la tranchée de largeur L2 dans la couche de contact Mo.
Bien entendu, il s'agit d'un exemple de réalisation. En variante, il est possible de prévoir un même faisceau balayant toute la surface de la gorge de largeur L1, puis d'appliquer ce faisceau ensuite sur la couche de contact Mo pour former la gorge de largeur L2.
Il convient de prévoir plusieurs tirs lasers successifs sur la surface à graver et, comme illustré sur la figure 4b, de prévoir en particulier des impacts de tirs lasers Imp1 et Imp2 qui se recouvrent partiellement, au moins en longueur.
Plus particulièrement, les tests réalisés montrent qu'il est préférable de prévoir, à proximité des fronts FR1 (à gauche de la gorge de largeur L1 sur la figure 3) et FR2 (à droite de la gorge de largeur L1 sur la figure 3), des tirs lasers formant des impacts Imp1 et Imp2 qui se recouvrent à la fois en longueur et en largeur, comme illustré sur la figure 4a. En particulier pour réaliser la gravure de la gorge délimitée par les fronts FR1 et FR2 de la couche de CIGS, il a été observé que les caractéristiques électriques des deux cellules ainsi connectées étaient meilleures selon un schéma d'impact conforme à la figure 4a appliqué près des fronts FR1 et FR2. Ces meilleures performances peuvent s'expliquer par des fronts plus raides de la couche de CIGS, et bien délimités, lorsque le schéma d'impacts est conforme à la figure 4a.
En revanche, loin de ces fronts FR1, FR2, et pour former la gorge de largeur L1, un schéma d'impacts selon la figure 4b (avec un simple recouvrement des impacts dans le sens de la longueur) peut être appliqué pour accélérer le traitement de gravure laser de la couche CIGS.

Dans un exemple de réalisation, la cadence des tirs lasers peut être comprise entre 100 kHz et 300 kHz pour obtenir des caractéristiques électriques satisfaisantes. Par ailleurs, on indique que la largeur L1 peut être de 300 µm (ou plus généralement comprise entre 200 et 500 µm) et que la largeur L2 est de 50 µm (ou plus généralement comprise entre 30 et 100 µm), pour une longueur de 600 millimètres de long.

Préférentiellement, le laser utilisé est à durée d'impulsion très brève, de type picoseconde (émettant par exemple dans l'ultraviolet), ou encore préférentiellement un laser à impulsion femtoseconde (pouvant émettre dans l'infrarouge proche ou le visible).

Il s'agit d'une gravure dite « sèche », par ablation laser.

La longueur d'onde utilisée pour la gravure de la couche de contact peut être située dans une gamme comprise entre 1000 et 1200 nm, par exemple 1030 nm. La longueur d'onde utilisée pour la gravure de la couche de CIGS peut être située dans une gamme de longueur d'onde comprise entre 400 et 600 nm, par exemple 515 nm. Toutefois, des tests réalisés avec une longueur d'onde comprise dans une gamme entre 1000 et 1200 nm (par exemple 1030 nm) ont donné aussi des résultats satisfaisants pour la gravure de la couche de CIGS.

On se réfère maintenant aux figures 5a et 5b pour décrire un exemple de réalisation de la gravure des deux tranchées de largeurs respectives L1 et L2. En référence à la figure 5a, il est possible de prévoir trois faisceaux lasers comme suit :
- un premier faisceau F1, par exemple de longueur d'onde 515 nm, est appliqué sur les bords de la tranchée (à proximité des fronts FR1 et FR2 prévus, représentés sur la figure 3) ; et
- un faisceau F2, de longueur d'onde de 1030 nm par exemple, pour graver la couche de CIGS, puis la couche de contact Mo.

Le faisceau F1 est un gaussien de diamètre de 30 à 50 µm (faisceau focalisé) par exemple. Il est appliqué avec une cadence de tir de 100 kHz pour produire des impacts comme illustré sur la figure 4a (avec un recouvrement à la fois dans le sens de la longueur et dans le sens de la largeur). Les deux faisceaux F1 représentés sur la figure 5a peuvent être activés ensemble, en tandem, et peuvent être issus d'une source laser commune à laquelle on applique une séparation optique (par exemple avec une lame semi-réfléchissante). La quantité d'énergie déposée, d'après les essais réalisés, ainsi que la fluence (en J/cm²), sont données dans le tableau présenté ci-après, selon des essais réalisés pour différentes compositions de la couche de CIGS et pour différents types de substrats SUB.

| Couche de CIGS | Longueur d'onde | Fluence | Quantité d'énergie déposée |
|---|---|---|---|
| CuInS₂ sur substrat en verre | 515nm | 0,42J/cm² | 0,18J/mm² |
| | 1030nm | 0,30J/cm² | 0,29J/mm² |
| CuInS₂ sur substrat métal | 515nm | 0,22J/cm² | 0,23J/mm² |
| | 1030nm | 0,35J/cm² | 0,26J/mm² |
| Cu-(In,Ga)-Se₂ sur substrat verre | 515nm | 0,29J/cm² | 0,29J/mm² |
| | 1030nm | 0,41J/cm² | 0,23J/mm² |

On grave ainsi un trait dans la couche de CIGS ayant une largeur de 30 à 50 µm, par applications (simultanées ou immédiatement successives) des faisceaux F1 sur la couche de CIGS.

On applique aussi le deuxième faisceau F2 d'abord sur la couche de CIGS, puis sur la couche de contact Mo, pour former la deuxième tranchée de largeur L2. Le diamètre du faisceau F2 (par exemple gaussien) est de 30 à 50 µm (faisceau focalisé). Il est possible de prévoir des tirs d'impulsion (à cadence de 100 KHz) formant des impacts conformes à la figure 4b avec un recouvrement des impacts seulement dans le sens de la longueur) et ce, tant pour la couche de CIGS que pour la couche de contact sous-jacente, du moment que ces tirs sont effectués à distance des fronts FR1 et FR2.

L'énergie par impulsion des tirs peut être de l'ordre de 20 µJ.

On notera qu'il est possible d'effectuer les gravures par les faisceaux F1 simultanément (par exemple à l'aide de deux sources lasers), mais aussi qu'il est possible de réaliser la gravure à l'aide du faisceau F2, simultanément avec la gravure des faisceaux F1.

On indique qu'en variante d'utilisation de sources lasers distinctes, il est possible d'utiliser une seule source laser divisée en plusieurs faisceaux par exemple parallèles (à l'aide d'un séparateur de faisceau tel qu'une « lame semi-réfléchissante » par exemple).

Ensuite, le procédé de gravure peut comprendre l'application d'un faisceau large F3, (un faisceau ellipsoïdal), de longueur d'onde de 515 nm ou 1030 nm, de largueur voisine de 300 µm, pour couvrir toute la largeur L1. Les cadences de tirs peuvent être conformes au schéma représenté sur figure 4b (avec un recouvrement seulement dans le sens de la longueur des impacts). En effet, il a été observé que seule la gravure de CGIS à proximité des fronts FR1 et FR2 était particulièrement critique pour l'obtention de caractéristiques électriques satisfaisantes. En revanche, la gravure au voisinage du milieu de la gorge L1 est moins critique, même si elle doit être effectuée de façon à évacuer le CIGS et éventuellement d'autres couches sous-jacentes (notamment une couche de MoSe₂ qui peut se former spontanément dans certaines conditions de fabrication de la couche de CIGS), en laissant un état de surface satisfaisant de la couche Mo.

Ainsi, pour la gravure représentée sur la figure 5b, il est possible de gagner du temps de gravure, par rapport à l'utilisation d'un faisceau gaussien avec plusieurs passages dans la largeur de la gorge.

Le procédé peut se poursuivre ensuite par l'ajout d'un isolant Is déposé notamment dans la gorge de largeur L2 comme représenté sur la figure 2, puis d'un contact Ag (par exemple en argent) déposé au-dessus de l'isolant, dans la gorge de largeur L1.

Bien entendu, la couche photovoltaïque CIGS est habituellement revêtue elle-même d'autres couches, transparentes, notamment d'une couche transparente conductrice souvent d'oxyde de zinc ZnO pour former une électrode de face avant de la cellule photovoltaïque, ainsi qu'une autre couche transparente de sulfure de cadmium CdS, qui sert quant à elle à former une jonction p-n à l'interface avec la couche photovoltaïque. Ces couches sont représentées sur la figure 6 commentée en détails plus loin. Ainsi, les gravures des première et deuxième tranchées précitées ont pour effet d'ôter, avec la couche photovoltaïque, ces couches transparentes ZnO et CdS, pour laisser à nu la couche de molybdène Mo dans la première tranchée, voire le substrat SUB dans la deuxième tranchée.

Il convient de noter que l'état de l'art classique pour la gravure de la couche de CIGS consistait jusque là à utiliser une pointe pour retirer le matériau dans une rainure entre deux cellules. Ce procédé n'est toutefois pas bien adapté pour réaliser la deuxième tranchée plus fine L2 dans la couche de contact. En outre, un tel procédé mécanique de l'état de la technique génère des écailles, notamment pour la gravure de la tranchée de largeur L1, comme expliqué ci-avant.

On se réfère maintenant à la figure 6 pour décrire un procédé selon une variante de réalisation de l'invention. La figure 6 présente en particulier une troisième tranchée T3 formée dans les couches transparentes ZnO, CdS et la couche photovoltaïque CIGS n'est que partiellement gravée, pour aller plus vite dans la formation de la connexion tout en isolant efficacement la cellule. Ici, du fait de la création de cette troisième tranchée T3, la gravure de la première tranchée n'a pas besoin d'être fine et précise à proximité des fronts FR1 et FR2 et elle peut être menée à l'aide d'un laser nanoseconde. Il en va de même pour la deuxième tranchée de largeur L2. En revanche, il est préférable que la gravure de la troisième tranchée T3 soit réalisée avec un laser d'impulsions plus courtes, typiquement avec un laser femtoseconde, pour soigner cette gravure. Cette réalisation prévoit ainsi une zone « sacrificielle » de matériau photovoltaïque entre la tranchée T3 et le front le plus proche FR2 de la première tranchée. Cette zone est préférentiellement de largeur inférieure ou égale à 50 µm.

Bien entendu, la présente invention ne se limite pas aux formes de réalisation décrites ci-avant à titre d'exemples illustratifs ; elle s'étend à d'autres variantes.

Ainsi, on comprendra qu'il est possible d'utiliser une même longueur d'onde pour réaliser des tirs lasers dans la couche de CIGS et dans la couche de contact Mo. En outre, un unique faisceau peut être utilisé et réaliser plusieurs passages dans la largeur L1 de la gorge formée dans la couche de CIGS.

En outre, plusieurs types de lasers (notamment de type femtoseconde, voire picoseconde) permettent d'obtenir de bons résultats au niveau des caractéristiques électriques mesurées sur la connexion de cellules, avec en particulier des fluences allant de 0,2 J/cm², jusqu'à 0,5 J/cm² et des quantités d'énergie déposées allant de 0,15 J/mm² jusqu'à 0,3 J/mm².

Dans le cadre des essais présentés ci-avant, l'épaisseur de la couche de CIGS était comprise entre 1,5 et 2,5 µm (par exemple 2µm) et l'épaisseur de la couche de contact était comprise entre 0,4 et 0,8 µm (par exemple 0,6 µm). Toutefois, d'autres gammes d'épaisseurs sont aussi envisageables.

Il convient de noter aussi que le procédé au sens de l'invention ici décrit s'applique aussi bien pour des substrats en verre que pour des substrats d'autres natures (en acier par exemple, avec éventuellement un isolant entre le substrat et la couche de molybdène), comme illustré par exemple par le tableau présenté ci-avant. En effet, le molybdène est un matériau électriquement conducteur satisfaisant notamment pour le dépôt par électrolyse. Ainsi, que le substrat soit en verre ou en métal, il est préférable que l'électrolyse soit réalisée sur molybdène. Aussi utilise-t-on un procédé au sens de l'invention pour résoudre le problème que pose le motif de gravure P1 de l'état de l'art (figure 1), avec un substrat en verre ou indistinctement en métal.

Plus généralement, on a décrit ci-avant un exemple de réalisation avec une couche à propriétés photovoltaïques, formée de CIGS. Toutefois, d'autres types de couches photovoltaïques par exemple à base de këstérite, de tellure de cadmium, ou autres, peuvent être traitées selon un procédé similaire à celui décrit ci-avant.

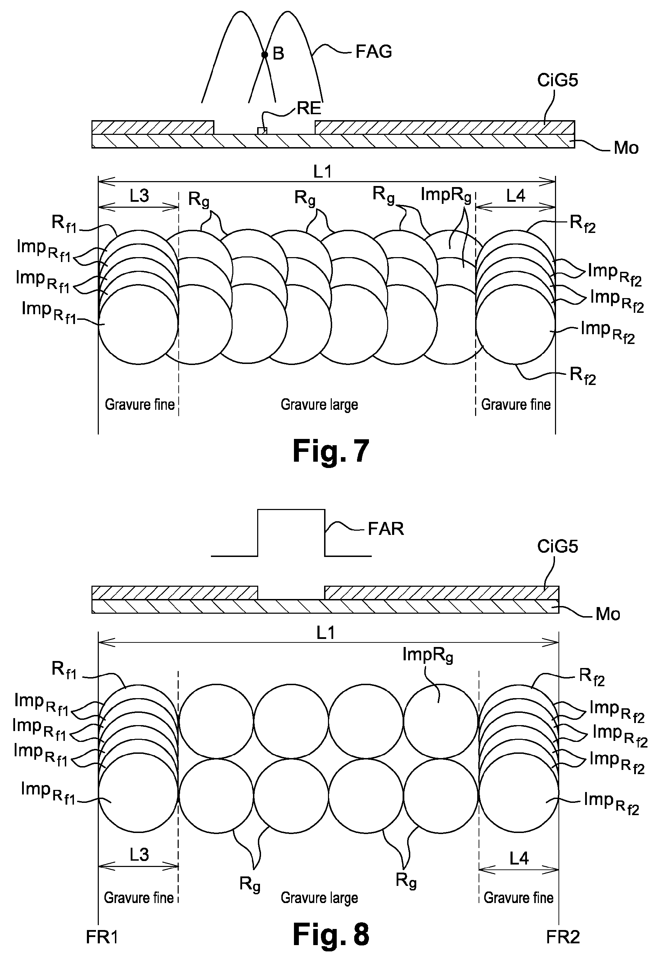

La figure 7 illustre les impacts de tirs lasers selon un second mode de réalisation qui constitue une alternative au mode décrit en références aux figures 4a et 4b.
Selon ce second mode de réalisation, le procédé selon l'invention comporte toujours une opération de gravure fine à proximité des bords latéraux de la première tranchée (les deux bords sont illustrés de façon schématique par deux lignes FR1 et FR2) et une opération de gravure grossière au milieu de la première tranchée. Les deux lignes FR1 et FR2 sont sensiblement parallèle et dirigée selon la longueur perpendiculaire à la largeur L1 de la tranchée.

L'opération de gravure fine est préférentiellement réalisée à l'aide d'un laser femtoseconde à faisceau sensiblement circulaire dont la longueur d'onde est comprise entre 400 et 600 nm.

Contrairement au cas de la figure 4a où la gravure fine se faisait suivant plusieurs rangées d'impacts de tirs lasers disposés successivement dans le sens de la largeur la tranchée, on réalise ici une gravure fine avec une seule rangée pour la réalisation de la gravure à proximité respective de chacun des fronts FR1 et FR2 (rangée Rf1 du côté du front FR1 et rangée Rf2 du côté du front FR2). Chacune des rangées Rf1 et Rf2 comporte respectivement une succession d'impacts (respectivement ImpRf1 et ImpRf2) disposés et se recouvrant partiellement suivant la longueur. Deux impacts successifs se recouvrent sensiblement suivant 90 à 95% de la surface totale de l'impact.

On notera que cette rangée unique est préférentiellement obtenue en faisant plusieurs passes de gravure laser de manière à creuser progressivement la rangée : en d'autres termes, on va réaliser plusieurs séries de tirs laser (chaque série ayant les mêmes positions d'impacts de tirs ImpRf1 et ImpRf2) pour enlever progressivement la matière (i.e. quelques centaines de nanomètres par passe). Ce retrait de matière en plusieurs passes permet de minimiser l'effet thermique sur la diode CIGS.

L'opération de gravure fine s'étend sur une largeur globale comprise entre 5 et 20% de la largeur de la première tranchée, par exemple de 10 à 20% à gauche et de 10 à 20% à droite dans la première tranchée.
La largeur L1 de la tranchée est par exemple de 400 µm, l'opération de gravure fine étant alors appliquée :
- sur une largeur L3 de la tranchée de 20 à 30 µm par exemple, compté en partant de son bord latéral gauche FR1 vers son milieu, et
- sur une largeur L4 de la tranchée de 20 à 30 µm par exemple, compté en partant de son bord latéral droit FR2 vers son milieu.

L'opération de gravure grossière est préférentiellement réalisée à l'aide d'un laser plus énergétique que le laser utilisé pour la gravure fine : il peut s'agir d'un laser pico- ou nanoseconde. Le faisceau de ce laser est ici sensiblement circulaire mais nous verrons par la suite qu'il est possible d'utiliser une autre forme (elliptique par exemple) pour le faisceau. Même si les faisceaux utilisés respectivement pour la gravure fine et la gravure grossière présentent dans le cas de la figure 7 un même diamètre, il peut s'avérer utile d'utiliser un faisceau de diamètre plus important dans le cas de la gravure grossière.

On réalise ici la gravure grossière avec une pluralité de rangées Rg pour la réalisation de la tranchée de largeur globale L1 entre les bords FR1 et FR2. Chacune des rangées Rg comporte respectivement une succession d'impacts (cf. par exemple les impacts ImpRg de la dernière rangée Rg avant la rangée Rf2) disposés et se recouvrant partiellement à la fois suivant la longueur et suivant la largeur. Deux impacts successifs d'une même rangée Rg se recouvrent sensiblement suivant 50 à 70% de la surface totale de l'impact : il convient de noter ici que ce recouvrement suivant la longueur est inférieur au recouvrement utilisé lors de l'opération de gravure fine.

Selon le mode de réalisation de la figure 7, deux impacts successifs suivant la direction de la largeur (i.e. deux impacts en vis-à-vis appartenant à deux rangées Rg successives) se recouvrent sensiblement suivant 20 à 30% de la surface totale de l'impact. On notera que ce recouvrement s'applique également entre deux impacts en vis-à-vis appartenant respectivement à une rangée Rf1 ou Rf2 et la rangée Rg qui suit ou qui précède. Selon ce mode de réalisation, l'énergie FAG du faisceau a ici une forme gaussienne (selon la direction parallèle à la largeur L1 de la tranchée) de sorte que l'énergie au bord B du faisceau n'est pas suffisante pour enlever totalement le CIGS. Toutefois, dans la mesure où le but du retrait du CIGS dans cette tranchée est de découvrir la zone de Mo pour y déposer un contact électrique, les quelques résidus RE qu'on peut laisser entre les endroits totalement gravés ne sont pas gênants (au moins jusqu'à un certain niveau, correspondant à la fourchette de recouvrement de 20 à 30% mentionnée plus haut).

Selon une alternative représentée en figure 8, deux impacts successifs d'une même rangée Rg ne se recouvrent pas ; de même, deux impacts en vis-à-vis appartenant respectivement à une rangée Rf1 ou Rf2 et la rangée Rg qui suit ou qui précède ne se recouvrent pas. Contrairement au cas de la figure 7, pour la figure 8, le faisceau est modifié pour prendre une répartition énergétique FAR non gaussienne et ayant une forme plus rectangulaire (désignée selon l'appellation « top-hat » en langue anglaise). Dans ce cas il n'y a pas de baisse d'énergie au bord du faisceau et donc moins de résidu non gravé. Les autres caractéristiques sont identiques à celles de la figure 7.

De manière préférentielle, en utilisant un laser plus énergétique pour la gravure grossière, les rangées Rg peuvent être réalisées en une seule passe de gravure laser. On entend par « une seule passe » le fait que le faisceau du laser utilisé pour la gravure grossière est suffisamment énergétique pour retirer la matière nécessaire à la réalisation de la tranchée en un seul passage au niveau de chaque impact ImpRg.

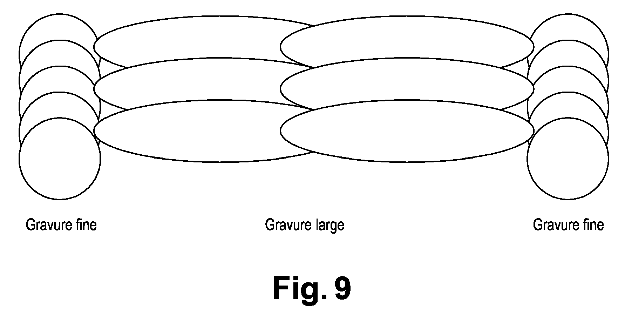

Selon une alternative illustrée en figure 9, le procédé selon l'invention utilise deux tailles de faisceaux différentes pour la réalisation respective des gravures fine et grossière. En l'espèce, le faisceau utilisé pour la gravure fine est circulaire et le faisceau utilisé pour la gravure grossière est elliptique. Dans ce cas, l'opération de gravure grossière est réalisée à l'aide d'un laser à faisceau plus large que le faisceau utilisé pour la gravure fine (i.e. le grand rayon de l'ellipse correspond au faisceau de la gravure grossière est supérieur au rayon du cercle du faisceau utilisé pour la gravure fine). Bien entendu, le grand-rayon de l'ellipse est orienté dans le sens de la largeur de la tranchée. On notera qu'il est également possible d'utiliser un faisceau circulaire pour la gravure grossière de plus grand rayon que le faisceau circulaire de la gravure fine. L'utilisation d'un faisceau plus large permet de réaliser la tranchée plus rapidement. A cet effet, l'utilisation d'un laser picoseconde pour la réalisation de la gravure grossière permet d'obtenir davantage de puissance et donc de faire des faisceaux plus larges.

## Revendications

1. Procédé de traitement de couches minces (CIGS, Mo), en vue d'une formation de connexion d'une cellule photovoltaïque (C1, C2) comportant lesdites couches minces, lesdites couches minces comportant au moins :
- une première couche (CIGS), à propriétés photovoltaïques, déposée sur une deuxième couche (Mo), et
- ladite deuxième couche, de contact métallique, déposée sur un substrat (SUB),
le procédé comportant les étapes :
- graver, dans ladite première couche (CIGS), au moins une première tranchée de première largeur (L1) pour une mise à nu de la deuxième couche (Mo) ; et
- graver, dans ladite première tranchée, une deuxième tranchée pour une mise à nu du substrat, la deuxième tranchée étant d'une deuxième largeur (L2) inférieure à la première largeur (L1),
les gravures des première et deuxième tranchées étant réalisées par tirs lasers, pendant une même étape globale de gravure,
le procédé étant **caractérisé en ce que** ladite étape globale de gravure comporte :
- une opération de gravure fine à proximité de fronts (FR1, FR2) destinés à délimiter la première tranchée, et
- une opération de gravure grossière entre les premier et deuxième fronts ; lesdites opérations de gravure fine et grossière étant choisies selon l'une des configurations suivantes :
- l'opération de gravure fine est réalisée par une gravure suivant une seule rangée d'impacts de tirs lasers se recouvrant partiellement dans le sens de la longueur de la tranchée et l'opération de gravure grossière est réalisée par une gravure suivant une pluralité de rangées, chacune des rangées comportant une succession d'impacts disposés et se recouvrant partiellement à la fois suivant la longueur et suivant la largeur, ce recouvrement suivant la longueur étant inférieur au recouvrement utilisé pour l'opération de gravure fine, le recouvrement s'appliquant également entre deux impacts en vis-à-vis appartenant respectivement à une rangée issue de la gravure fine et à une rangée issue de la gravure grossière qui suit ou qui précède ;
- l'opération de gravure fine est réalisée par une gravure suivant une seule rangée d'impacts de tirs lasers se recouvrant partiellement dans le sens de la longueur de la tranchée et l'opération de gravure grossière est réalisée par une gravure suivant une pluralité de rangées avec deux impacts d'une même rangée ne se recouvrant pas, deux impacts en vis-à-vis appartenant respectivement à une rangée issue de la gravure fine et à une rangée de la gravure grossière ne se recouvrant également pas ;
- l'opération de gravure fine est réalisée par une gravure entraînant un recouvrement en largeur et en longueur des impacts issus des tirs lasers suivant une pluralité de rangées d'impacts de tirs lasers et l'opération de gravure grossière est réalisée par une gravure entraînant un simple recouvrement des impacts de tirs laser dans le sens de la longueur.

2. Procédé selon la revendication 1, **caractérisé en ce que** l'opération de gravure grossière est réalisée à l'aide d'un laser à faisceau plus large que le faisceau utilisé pour la gravure fine.

3. Procédé selon l'une des revendications précédentes, **caractérisé en ce que** l'opération de gravure fine est réalisée à l'aide d'un laser femtoseconde.

4. Procédé selon la revendication précédente **caractérisé en ce que** la longueur d'onde dudit laser femtoseconde est comprise entre 400 et 600 nm.

5. Procédé selon l'une des revendications précédentes, **caractérisé en ce que** le faisceau utilisé pour l'opération de gravure fine est un faisceau circulaire.

6. Procédé selon l'une des revendications précédentes, **caractérisé en ce que** l'opération de gravure grossière est réalisée à l'aide d'un laser picoseconde ou nanoseconde.

7. Procédé selon l'une des revendications précédentes, **caractérisé en ce que** l'opération de gravure grossière est réalisée à l'aide d'un laser à faisceau elliptique.

8. Procédé selon l'une des revendications précédentes, **caractérisé en ce que** ladite opération de gravure fine est réalisée, à proximité respective de chacun des fronts, selon une seule rangée d'impacts de tirs lasers, lesdits impacts se recouvrant partiellement selon la direction de ladite rangée longeant chacun desdits fronts.

9. Procédé selon la revendication précédente **caractérisé en ce que** ladite rangée unique d'impacts de tirs lasers est obtenue en plusieurs passes de gravure laser, chaque passe venant creuser davantage ladite rangée.

10. Procédé selon l'une des revendications précédentes **caractérisé en ce que** ladite opération de gravure grossière est réalisée selon une ou plusieurs rangée d'impacts de tirs laser obtenue en une unique passe de gravure laser.

11. Procédé selon l'une des revendications précédentes **caractérisé en ce que** l'opération de gravure fine s'étend sur une largeur globale comprise entre 5 et 20% de la largeur séparant le premier front du deuxième front.

12. Procédé selon l'une des revendications précédentes **caractérisé en ce que** :
- ladite opération de gravure fine est réalisée avec des tirs lasers formant des impacts se recouvrant partiellement selon une dimension longeant chacun desdits fronts, et
- ladite opération de gravure grossière est réalisée avec des tirs lasers formant des impacts se recouvrant partiellement selon la même dimension longeant chacun desdits fronts,
le recouvrement partiel des impacts lors de l'opération de gravure fine étant supérieur au recouvrement partiel lors de l'opération de gravure grossière.

13. Procédé selon l'une des revendications 1 à 7, **caractérisé en ce que** :
- ladite opération de gravure fine est réalisée avec des tirs lasers formant des impacts (Imp1, Imp2) se recouvrant partiellement selon deux dimensions de surface de la première couche et/ou de la deuxième couche , et
- ladite opération de gravure grossière est réalisée avec des tirs lasers formant des impacts (Imp1, Imp2) se recouvrant partiellement selon une seule dimension de surface de la première couche et/ou de la deuxième couche

14. Procédé selon la revendication précédente **caractérisé en ce que** l'opération de gravure fine s'étendant sur une largeur globale comprise entre 20 et 40% de la largeur (L1) séparant le premier front du deuxième front.

15. Procédé selon l'une des revendications précédentes, **caractérisé en ce que** la deuxième tranchée au moins est réalisée à l'aide d'un laser à faisceau gaussien (F2).

16. Procédé selon l'une des revendications précédentes, **caractérisé en ce que** la deuxième tranchée au moins est réalisée à l'aide d'un laser femtoseconde de longueur d'onde comprise entre 1000 et 1200 nm.

17. Procédé selon l'une des revendications précédentes, **caractérisé en ce que**, la première couche (CIGS) étant revêtue d'au moins une troisième couche (ZnO, CdS), transparente, le procédé comporte en outre une gravure d'une troisième tranchée (T3) dans la troisième couche (ZnO, CdS) pour une mise à nu de la première couche (CIGS), et **en ce que** :
- la gravure de la troisième tranchée (T3) est réalisée à l'aide d'un laser femtoseconde,
- la gravure des première et deuxième tranchées est réalisée à l'aide d'un laser nanoseconde.

18. Procédé selon l'une des revendications précédentes, **caractérisé en ce que** la première couche (CIGS), à propriétés photovoltaïques, est à base d'un matériau de stoechiométrie I-III-VI₂.

19. Procédé selon l'une des revendications précédentes, **caractérisé en ce que** la première couche (CIGS) est revêtue d'au moins une troisième couche transparente (ZnO, CdS), et **en ce que** la première tranchée au moins (L1) est formée dans la première et la troisième couche.

## Patentansprüche

1. Verarbeitungsverfahren von dünnen Schichten (CIGS, Mo) zwecks Bildung der Verbindung einer photovoltaischen Zelle (C1, C2), umfassend die genannten dünnen Schichten, umfassend mindestens:
- eine erste Schicht (CIGS) mit photovoltaischen Eigenschaften, die auf einer zweiten Schicht (Mo) aufgebracht ist, und
- die genannte zweite Schicht mit metallischem Kontakt, die auf einem Substrat (SUB) aufgebracht ist,
wobei das Verfahren die Stufen umfasst:
- Gravieren wenigstens eines ersten Grabens mit einer ersten Breite (L1) in der genannten ersten Schicht (CIGS) für ein Freilegen der zweiten Schicht (Mo); und
- Gravieren eines zweiten Grabens in dem genannten ersten Graben für ein Freilegen des Substrats, wobei der zweite Graben um eine zweite Breite (L2) geringer ist als die erste Breite (L1),
wobei die Gravuren der ersten und zweiten Gräben durch Laserschüsse während eines und desselben globalen Gravurschritts realisiert sind,
wobei das Verfahren **dadurch gekennzeichnet ist, dass** der genannte globale Gravurschritt umfasst:
- eine Feingravuroperation in der Nähe von Fronten (FR1, FR2), die dazu bestimmt sind, den ersten Graben zu begrenzen, und
- eine Grobgravuroperation zwischen der ersten und der zweiten Front;
wobei die genannten Fein- und Grobgravuroperationen gemäß einer der nachstehenden Konfigurationen ausgewählt sind:
- die Feingravuroperation ist durch eine Gravur gemäß einer einzigen Auftrefffläche von Laserschüssen realisiert, die sich in der Richtung der Länge des Grabens teilweise üblagern und die Grobgravuroperation ist durch eine Gravur gemäß einer Vielzahl von Reihen realisiert, wobei jede der Reihen eine Folge von angeordneten Auftreffern umfasst und sich teilweise gleichzeitig gemäß der Länge und gemäß der Breite überlagert, wobei diese Überlagerung gemäß der Länge geringer ist als die für die Feingravuroperation verwendete Überlagerung, wobei die Überlagerung ebenfalls zwischen zwei Auftreffern gegenüber zur Anwendung kommt, die jeweils zu einer Reihe, die aus der Feingravur hervorgegangen ist, und zu einer Reihe, die aus der Grobgravur hervorgegangen ist, die folgt oder vorangeht, gehören;
- die Feingravuroperation ist durch eine Gravur gemäß einer einzigen Auftrefferreihe von Laserschüssen realisiert, die sich in der Richtung der Länge des Grabens teilweise überlagern, und die Grobgravuroperation ist durch eine Gravur gemäß einer Vielzahl von Reihen mit zwei Auftreffern einer und derselben Reihe realisiert, die sich nicht überlagern, wobei zwei Auftreffer gegenüber jeweils zu einer Reihe gehören, die aus der Feingravur und aus einer Reihe der Grobgravur, die sich ebenfalls nicht überlagern, hervorgegangen ist;
- die Feingravuroperation ist durch eine Gravur realisiert, die eine Überlagerung der aus den Laserschüssen hervorgegangenen Auftreffern in der Breite und in der Länge gemäß einer Vielzahl von Auftrefferreihen von Laserschüssen nach sich zieht und die Grobgravuroperation ist durch eine Gravur realisiert, die eine einfache Überlagerung der Auftreffer von Laserschüssen in der Längsrichtung nach sich zieht.

2. Verfahren gemäß Anspruch 1, **dadurch gekennzeichnet, dass** die Grobgravuroperation mithilfe eines Lasers mit breiterem Strahl realisiert ist als der für die Feingravur verwendete Strahl.

3. Verfahren gemäß einem der voranstehenden Ansprüche, **dadurch gekennzeichnet, dass** die Feingravur mithilfe eines Femtosekundenlasers realisiert ist.

4. Verfahren gemäß dem voranstehenden Anspruch, **dadurch gekennzeichnet, dass** die Wellenlänge des genannten Femtosekundenlasers zwischen 400 und 600 nm inbegriffen ist.

5. Verfahren gemäß einem der voranstehenden Ansprüche, **dadurch gekennzeichnet, dass** der für die Feingravur verwendete Strahl ein kreisförmiger Strahl ist.

6. Verfahren gemäß einem der voranstehenden Ansprüche, **dadurch gekennzeichnet, dass** die Grobgravuroperation mithilfe eines Pikosekundenlasers oder eines Nanosekundenlasers realisiert ist.

7. Verfahren gemäß einem der voranstehenden Ansprüche, **dadurch gekennzeichnet, dass** die Grobgravuroperation mithilfe eines Lasers mit elliptischem Strahl realisiert ist.

8. Verfahren gemäß einem der voranstehenden Ansprüche, **dadurch gekennzeichnet, dass** die genannte Feingravuroperation in der jeweiligen Nähe jeder der Fronten gemäß einer einzigen Auftrefferreihe von Laserschüssen realisiert ist, wobei die genannten Auftreffer sich teilweise gemäß der Richtung der genannten Reihe überlagern, die jeweils an den genannten Fronten entlanglaufen.

9. Verfahren gemäß einem dem voranstehenden Ansprüche, **dadurch gekennzeichnet, dass** die genannte einzige Reihe von Auftreffern von Laserschüssen in mehreren Lasergravurdurchgängen erhalten wird, wobei jeder Durchgang die genannte Reihe nach noch mehr aushöhlt.

10. Verfahren gemäß einem der voranstehenden Ansprüche, **dadurch gekennzeichnet, dass** die genannte Grobgravuroperation gemäß einer oder mehreren Auftrefferreihen von Laserschüssen realisiert ist, die in einem einzigen Lasergravurdurchgang erhalten wird.

11. Verfahren gemäß einem der voranstehenden Ansprüche, **dadurch gekennzeichnet, dass** die Feingravuroperation sich auf eine globale Breite erstreckt, die zwischen 5 und 20 % der Breite inbegriffen ist, die die erste Front von der zweiten Front trennt.

12. Verfahren gemäß einem der voranstehenden Ansprüche, **dadurch gekennzeichnet, dass**:
- die genannte Feingravuroperation mit Laserschüssen realisiert ist, die Auftreffer bilden, die sich gemäß einer Abmessung teilweise überlagern, die an jeder der genannten Fronten entlangläuft, und
- die genannte Grobgravuroperation mit Laserschüssen realisiert ist, die Auftreffer bilden, die sich teilweise gemäß derselben Abmessung überlagern, die an jeder der genannten Fronten entlangläuft,
wobei die teilweise Abdeckung der Auftreffer bei der Feingravuroperation größer ist als die teilweise Überlagerung bei der Grobgravuroperation.

13. Verfahren gemäß einem der Ansprüche 1 bis 7, **dadurch gekennzeichnet, dass**:
- die genannte Feingravuroperation mit Laserschüssen realisiert wird, die Auftreffer (Imp1, Imp2) bilden, die sich teilweise gemäß zwei Oberflächenabmessungen der ersten Schicht und / oder der zweiten Schicht überlagern und
- die genannte Grobgravuroperation mit Laserschüssen realisiert wird, die Auftreffer (Imp1, Imp2) bilden, die sich teilweise gemäß einer einzigen Oberflächenabmessung der ersten Schicht und / oder der zweiten Schicht überlagern.

14. Verfahren gemäß dem voranstehenden Anspruch, **dadurch gekennzeichnet, dass** die Feingravuroperation sich auf eine globale Breite erstreckt, die zwischen 20 und 40 % der Breite (L1) inbegriffen ist, die die erste Front von der zweiten Front trennt.

15. Verfahren gemäß einem der voranstehenden Ansprüche, **dadurch gekennzeichnet, dass** der zweite Graben wenigstens mithilfe eines Lasers mit Gaußschem Strahl (F2) realisiert ist.

16. Verfahren gemäß einem der voranstehenden Ansprüche, **dadurch gekennzeichnet, dass** der zweite Graben wenigstens mithilfe eines Femtosekundenlasers mit einer zwischen 1000 und 1200 mm inbegriffenen Länge realisiert ist.

17. Verfahren gemäß einem der voranstehenden Ansprüche, **dadurch gekennzeichnet, dass**, da die erste Schicht (CIGS) mit wenigstens einer transparenten dritten Schicht (ZnO, CdS) beschichtet ist, das Verfahren darüber hinaus eine Gravur eines dritten Grabens (T3) in der dritten Schicht (ZnO, CdS) für ein Freilegen der ersten Schicht (CIGS) umfasst, und dass:
- die Gravur des dritten Grabens (T3) mithilfe eines Femtosekundenlasers realisiert ist,
- die Gravur des ersten und des zweiten Grabens mithilfe eines Nanosekundenlasers realisiert ist.

18. Verfahren gemäß einem der voranstehenden Ansprüche, **dadurch gekennzeichnet, dass** die erste Schicht (CIGS) mit photovoltaischen Eigenschaften, auf einem Stoechiometrie-Material I-III-VI₂ basiert.

19. Verfahren gemäß einem der voranstehenden Ansprüche, **dadurch gekennzeichnet, dass** die erste Schicht (CIGS) mit wenigstens einer transparenten dritten Schicht (ZnO, CdS) beschichtet ist und dass der erste Graben wenigstens (L1) in der ersten und der dritten Schicht gebildet ist.

## Claims

1. Method for treating thin layers (CIGS, Mo), with a view to forming a connection of a photovoltaic cell (C1, C2) comprising said thin layers, said thin layers comprising at least:
- a first layer (CIGS), having photovoltaic properties, deposited on a second layer (Mo), and
- said second layer, a metal contact layer, deposited on a substrate (SUB),
the method comprising the steps:
- etching, in said first layer (CIGS), at least one first trench having a first width (L1) so as to expose the second layer (Mo); and
- etching, in said first trench, a second trench so as to expose the substrate, the second trench having a second width (L2) less than the first width (L1),
the etchings of the first and second trenches being carried out by laser shots, during a single overall etching step,
the method being **characterised in that** said overall etching step comprises:
- a fine etching operation close to fronts (FR1, FR2) intended to delimit the first trench, and;
- a coarse etching operation between the first and second fronts;
said fine and coarse etching operations being chosen according to one of the following configurations:
- the fine etching operation is carried out by an etching along a single row of laser shot impacts partially overlapping in the sense of the length of the trench and the coarse etching operation is carried out by an etching along a plurality of rows, each of the rows comprising a succession of impacts arranged and partially overlapping both along the length and along the width, this overlapping along the length being less than the overlap used for the fine etching operation, the overlap also applying between two facing impacts belonging respectively to a row from the fine etching and to a row from the coarse etching that follows or precedes;
- the fine etching operation is carried out by an etching along a single row of laser shot impacts partially overlapping in the sense of the length of the trench and the coarse etching operation is carried out by an etching along a plurality of rows with two impacts of a same row not overlapping, two opposite impacts belonging respectively to a row from the fine etching and a row from the coarse etching also not overlapping;
- the fine etching operation is carried out by an etching leading to an overlap in width and in length of the impacts from laser shots along a plurality of laser shot impact rows and the coarse etching operation is carried out by an etching leading to a simple overlap of the laser shot impacts in the sense of the length.

2. Method according to claim 1, **characterised in that** the coarse etching operation is carried out using a laser with a beam wider than the beam used for the fine etching.

3. Method according to one of the preceding claims, **characterised in that** the fine etching operation is carried out using a femtosecond laser.

4. Method according to the preceding claim, **characterised in that** the wavelength of said femtosecond laser is comprised between 400 and 600 nm.

5. Method according to one of the preceding claims, **characterised in that** the beam used for the fine etching operation is a circular beam.

6. Method according to one of the preceding claims, **characterised in that** the coarse etching operation is carried out using a picosecond or nanosecond laser.

7. Method according to one of the preceding claims, **characterised in that** the coarse etching operation is carried out using an elliptical laser.

8. Method according to one of the preceding claims, **characterised in that** said fine etching operation is carried out, respectively near to each of the fronts, along a single row of laser shot impacts, said impacts partially overlapping along the direction of said row running along each of said fronts.

9. Method according to the preceding claim, **characterised in that** said single row of laser shot impacts is obtained in several laser etching passes, each pass further hollowing out said row.

10. Method according to one of the preceding claims, **characterised in that** said coarse etching operation is carried out along one or more rows of laser shot impacts obtained in a single laser etching pass.

11. Method according to one of the preceding claims, **characterised in that** the fine etching operation extends over an overall width comprised between 5 and 20% of the width separating the first front from the second front.

12. Method according to one of the preceding claims, **characterised in that**:
- said fine etching operation is carried out with laser shots forming impacts partially overlapping along a dimension running along each of said fronts, and
- said coarse etching operation is carried out with laser shots forming impacts partially overlapping along the same dimension running along each of said fronts,
the partial overlap of the impacts during the fine etching operation being greater than the partial overlap during the coarse etching operation.

13. Method according to one of claims 1 to 7, **characterised in that**:
- said fine etching operation is carried out with laser shots forming impacts (Imp1, Imp2) partially overlapping along two surface dimensions of the first layer and/or the second layer, and
- said coarse etching operation is carried out with laser shots forming impacts (Imp1, Imp2) partially overlapping along a single surface dimension of the first layer and/or the second layer.

14. Method according to the preceding claim, **characterised in that** the fine etching operation extending over an overall width comprised between 20 and 40% of the width (L1) separating the first front from the second front.

15. Method according to one of the preceding claims, **characterised in that** the second trench at least is formed using a Gaussian beam laser (F2).

16. Method according to one of the preceding claims, **characterised in that** the second trench at least is formed using a femtosecond laser with a wavelength comprised between 1000 and 1200 nm.

17. Method according to one of the preceding claims, **characterised in that**, the first layer (CIGS) being covered by at least one transparent third layer (ZnO, CdS), the method further comprising an etching of a third trench (T3) in the third layer (ZnO, CdS) so as to expose the first layer (CIGS), and **in that**:
- the etching of the third trench (T3) is carried out using a femtosecond laser,
- the etching of the first and second trenches is carried out using a nanosecond laser.

18. Method according to one of the preceding claims, **characterised in that** the first layer (CIGS), with photovoltaic properties, is based on material with I-III-VI₂ stoichiometry.

19. Method according to one of the preceding claims, **characterised in that** the first layer (CIGS) is coated with at least one transparent third layer (ZnO, CdS), and **in that** the first trench at least (L1) is formed in the first and the third layer.
